# EUROPEAN PATENT APPLICATION

(11) **EP 1 843 170 A1**
(43) Date of publication of application: **10.10.2007**
(21) Application number: 06712512.0
(22) Date of filing: 27.01.2006
(51) Int. Cl.: G01S 7/282, H01Q 9/40, H01Q 21/06, H03B 5/06, H03B 5/12

(54) **UWB SHORT PULSE RADAR**

(30) Priority: 28.01.2005 JP 2005021627
(71) Applicant: Anritsu Corporation, Atsugi-shi Kanagawa 243-8555 (JP); Matsushita Electric Industrial Co., Ltd., Kadoma-shi, Osaka 571-8501 (JP)
(72) Inventor: TESHIROGI, Tasuku Anritsu Corporation, Kanagawa, 243-8555 (JP); SAITO, Sumio Anritsu Corporation, Kanagawa, 243-8555 (JP); UCHINO, Masaharu Anritsu Corporation, Kanagawa, 243-8555 (JP); EJIMA, Masanori Anritsu Corporation, Kanagawa, 243-8555 (JP)
(74) Representative: Pautex Schneider, Nicole Véronique
(86) International application number: PCT/JP2006/301346
(87) International publication number: WO 2006/080454

(57) **Abstract**

A transmitting unit emits a short pulse wave which satisfies a predetermined spectrum mask from an antenna into space. A receiving unit receives a reflected wave produced by an object existing in space of the short pulse wave emitted by the transmitting unit. A signal processing unit analyzes the object based on an output signal from the receiving unit. The transmitting unit has a pulse generator which outputs pulse signals each having a predetermined width at a predetermined frequency, and a burst oscillator which receives the pulse signal output from the pulse generator and performs an oscillation operation for time corresponding to the width of the pulse signal to output the short pulse signal. A width and a cycle of the pulse signal and an oscillation frequency of the burst oscillator are set such that almost an entire main lobe of a spectrum of the short pulse wave falls within a range of 24.0 to 29.0 GHz in the predetermined spectrum mask, and that a radiation power density to an RR radiowave emission prohibited band held by the predetermined spectrum mask is lower than a peak radiation power density of the main lobe by not less than 20 dB.

## Description

### Technical Field

The present invention relates to UWB short-range radars, and more particularly, to UWB short-range radars employing a technique to make it possible to cause a short-range radar used in an ultra-wideband (UWB) of 22 to 29 GHz to conform to the rules of International Radio Communication Regulations (RR).

### Background Art

A short-range radar using a UWB is tried to be practically used as an automotive short-range radar or a radar for people with visual impairment.

A short-range radar using a UWB, like a normal radar, emits a short pulse wave from an antenna of a transmitting unit into space and receives a reflected wave from an object existing in space to perform an analyzing process for the object.

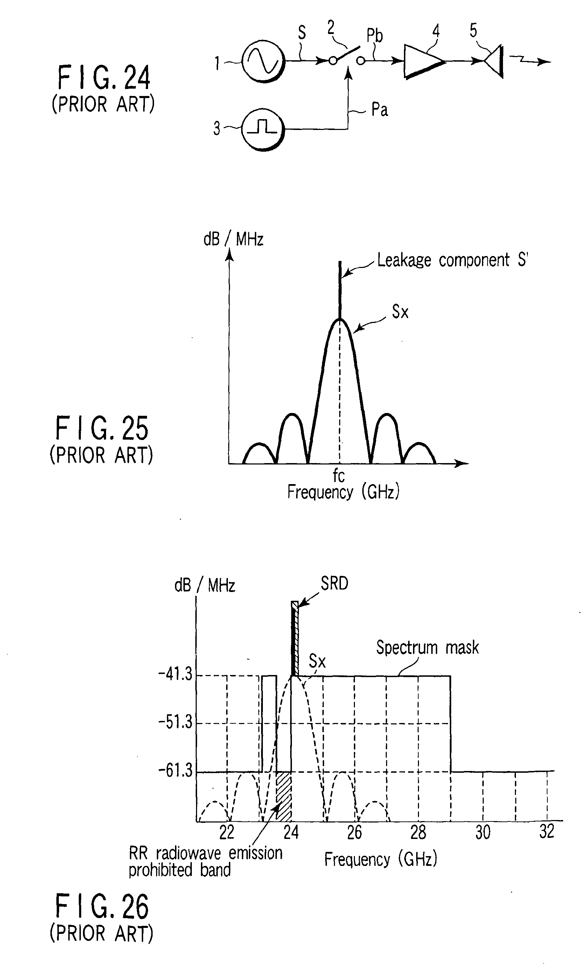

FIG. 24 shows a schematic configuration of a transmitting unit of a short-range radar of this type.

More specifically, the transmitting unit receives a carrier signal S of a predetermined frequency in a UWB output from a carrier signal generator 1 through a switch circuit 2, turns on/off the switch circuit 2 by a pulse signal Pa output from a pulse generator 3 at a predetermined frequency to generate a short pulse Pb, amplifies the short pulse Pb by an amplifier 4, and outputs the amplified short pulse Pb from an antenna 5.

### Disclosure of Invention

However, the configuration in which the switch circuit 2 set in the path for the carrier signal S is opened or closed to generate a short pulse Pb has the following problem. Due to leakage caused by incomplete isolation of the switch circuit 2, outputting of the carrier signal cannot be completely stopped.

In particular, in the UWB having a high frequency, it is difficult to prevent carrier leakage, and pulse-off time is approximately four times pulse-on time in a short-range radar using a UWB. For this reason, a power of the carrier leakage becomes very high. As a result, a spectrum density Sx of the short pulse Pb has a characteristic that, for example, as shown in FIG. 25, a leakage component S' considerably outstands at a position corresponding to a carrier frequency fc.

This leakage component S' restricts a substantial receiving sensitivity of a reflected wave to a short pulse wave output at a normal transmission timing to narrow a radar search area, which makes it difficult to detect a low-reflectance obstacle.

With respect to the UWB radar system, the Federal Communications Commission (FCC) of USA regulates a spectrum mask shown in FIG. 26 in the following
Non-patent Document 1.
FCC 04-285 SECOND REPORT AND ORDER AND SECOND

### MEMORANDAM OPINION AND ORDER

### December 16, 2004

This spectrum mask was disclosed on December 16th, 2004. The spectrum mask is regulated accurately more than a previous spectrum mask.

In the spectrum mask, in a UWB, power densities in a range of 1.61 to 23.12 GHz and a range of 29.0 GHz or more are regulated to -61.3 dBm/MHz or less, and power densities in a range of 23.12 to 23.6 GHz and a range of 24.0 to 29.0 GHz are regulated to -41.3 dBm/MHz or less.

In order to protect a passive sensor for radio astronomy or exploration satellite service (EESS), in a so-called RR radiowave emission prohibited band (also called a restricted band) ranging from 23.6 to 24.0 GHz in which radiowave emission is intentionally prohibited by International Radio Communication Regulations (RR), the power density is suppressed to -61.3 dBm/MHz which is lower than a conventional radiation power density by 20 dB.

The radiation power density in the band is restricted. For this reason, when the leakage component S' is large as described above, an output level at the normal transmission timing must be set to be low accordingly, and an exploration distance or the like must be considerably restricted.

Therefore, as shown in FIG. 26, in the UWB, a carrier frequency of the short pulse Pb may be matched with a band (short-range device [SRD]) ranging from 24.05 to 24.25 GHz for a Doppler radar which is allowed to emit a power at a density of -41.3 dBm/MHz to avoid a problem caused by the leakage component S'.

However, the RR radiowave emission prohibited band is present near the SRD band, and furthermore, a pulse modulation signal obtained by intermitting a carrier signal by a pulse signal as described above has a spectrum width of several 100 MHz to 2 GHz. For this reason, when a carrier frequency is set in the SRD band near the RR radiowave emission prohibited band, a part having a considerably high level of the short pulse spectrum overlaps the RR radiowave emission prohibited band. Consequently, it is difficult to suppress the power density to -61.3 dBm or less unlike in the latest spectrum mask described above.

In the RR radiowave emission prohibited band, a radiation intensity in a range exceeding 30° is regulated to be -25 dB or less for a radiation intensity at radiation angles 0° to 30° (June 2005 or later) with respect to a radiation direction (elevation angle direction) on a vertical plane of a radiowave used for another target on the earth, in order to avoid an earth exploration satellite from being hindered. The regulations have become stricter every several years.

Therefore, when the carrier frequency is set in the SRD band, the range of a radiation angle of a vertical plane of an antenna must be suppressed to prevent a radiation direction of the transmitted radiowave from being high.

However, in order to suppress the range of the radiation angle of the vertical plane of the antenna, a large number of antenna elements must be arranged in a direction of height to form an array. Height increases make it difficult to mount the radar in an automobile. In order to solve the problems of the prior art, it is an object of the present invention to provide a UWB short-range radar which realizes a scheme being free from leakage of a carrier signal in a UWB, and thereby prevents an RR radiowave emission prohibited band and an SRD band from being hindered while conforming to a spectrum mask regulated as a UWB radar.

In order to achieve the above object, according to a first aspect of the present invention, there is provided a UWB short-range radar comprising:
a transmitting unit (32) which emits a short pulse wave (Pt) which satisfies a predetermined spectrum mask from an antenna (33) into space (1);
a receiving unit (40) which receives a reflected wave (Pr) produced by an object (1a) existing in the space of the short pulse wave emitted by the transmitting unit; and
a signal processing unit (61) which performs an analyzing process for the object based on an output signal from the receiving unit,
wherein
the transmitting unit has:
   a pulse generator (23) which outputs pulse signals each having a predetermined width at a predetermined frequency; and
   a burst oscillator (24) which receives the pulse signal output from the pulse generator and performs an oscillation operation for time corresponding to the width of the pulse signal to output a short pulse signal serving as the short pulse wave, and
   a width and a cycle of the pulse signal output from the pulse generator and an oscillation frequency of the short pulse signal output from the burst oscillator are set such that almost an entire main lobe of a spectrum of the short pulse wave emitted from the antenna into the space falls within a range of 24.0 to 29.0 GHz in the predetermined spectrum mask, and that a radiation power density to an RR radiowave emission prohibited band held by the predetermined spectrum mask is lower than a peak radiation power density of the main lobe by not less than 20 dB.

In order to achieve the above object, according to a second aspect of the present invention, there is provided a UWB short-range radar according to the first aspect, wherein
both ends of the main lobe of the spectrum of the short pulse wave output from the burst oscillator falls within a range of 24.0 to 29.0 GHz in the predetermined spectrum mask.

In order to achieve the above object, according to a third aspect of the present invention, there is provided a UWB short-range radar according to the first aspect, wherein
a side lobe on a low-frequency side of the main lobe of the spectrum of the short pulse wave output from the burst oscillator overlaps the RR radiowave emission prohibited band held by the predetermined spectrum mask.

In order to achieve the above object, according to a fourth aspect of the present invention, there is provided a UWB short-range radar according to the first aspect, wherein
the burst oscillator is constituted by:
an oscillation unit (24a) comprising a signal inverter (25) and a feedback circuit (26) which delays an output signal from the signal inverter to feed back to an input terminal, the oscillation unit performing oscillation at a frequency determined by input/output response time of the signal inverter and delay time of the feedback circuit; and
a switch circuit (24b) which sets the oscillation unit in an oscillation state only in a period in which the pulse signal output from the pulse generator is received.

In order to achieve the above object, according to a fifth aspect of the present invention, there is provided a UWB short-range radar according to the second aspect, wherein
the burst oscillator is constituted by:
an oscillation unit (24a) comprising a signal inverter (25) and a feedback circuit (26) which delays an output signal from the signal inverter to feed back to an input terminal, the oscillation unit performing oscillation at a frequency determined by input/output response time of the signal inverter and delay time of the feedback circuit; and
a switch circuit (24b) which sets the oscillation unit in an oscillation state only in a period in which the pulse signal output from the pulse generator is received.

In order to achieve the above object, according to a sixth aspect of the present invention, there is provided a UWB short-range radar according to the third aspect, wherein
the burst oscillator is constituted by:
an oscillation unit (24a) comprising a signal inverter (25) and a feedback circuit (26) which delays an output signal from the signal inverter to feed back to an input terminal, the oscillation unit performing oscillation at a frequency determined by input/output response time of the signal inverter and delay time of the feedback circuit; and
a switch circuit (24b) which sets the oscillation unit in an oscillation state only in a period in which the pulse signal output from the pulse generator is received.

In order to achieve the above object, according to a seventh aspect of the present invention, there is provided a UWB short-range radar according to the first aspect, wherein
the burst oscillator is constituted by:
an oscillation unit (24a) comprising an amplifier (72), a resonator (73) connected to an input unit or an output unit of the amplifier, and a feedback circuit (74) which performs positive feedback from an output side of the amplifier to an input side of the amplifier, the oscillation unit performing oscillation at a frequency determined by the resonator; and
a switch circuit (24b) which sets the oscillation unit in an oscillation state only in a period in which the pulse signal output from the pulse generator is received.

In order to achieve the above object, according to an eighth aspect of the present invention, there is provided a UWB short-range radar according to the second aspect, wherein
the burst oscillator is constituted by:
an oscillation unit (24a) comprising an amplifier (72), a resonator (73) connected to an input unit or an output unit of the amplifier, and a feedback circuit (74) which performs positive feedback from an output side of the amplifier to an input side of the amplifier, the oscillation unit performing oscillation at a frequency determined by the resonator; and
a switch circuit (24b) which sets the oscillation unit in an oscillation state only in a period in which the pulse signal output from the pulse generator is received.

In order to achieve the above object, according to a ninth aspect of the present invention, there is provided a UWB short-range radar according to the third aspect, wherein
the burst oscillator is constituted by:
an oscillation unit (24a) comprising an amplifier (72), a resonator (73) connected to an input unit or an output unit of the amplifier, and a feedback circuit (74) which performs positive feedback from an output side of the amplifier to an input side of the amplifier, the oscillation unit performing oscillation at a frequency determined by the resonator; and
a switch circuit (24b) which sets the oscillation unit in an oscillation state only in a period in which the pulse signal output from the pulse generator is received.

In order to achieve the above object, according to a tenth aspect of the present invention, there is provided a UWB short-range radar according to the first aspect, wherein
the transmitting unit is provided with a filter (31) which suppresses a component having a frequency ranging from 23.6 to 24.0 GHz of a frequency component included in the short pulse wave output from the burst oscillator.

In order to achieve the above object, according to an eleventh aspect of the present invention, there is provided a UWB short-range radar according to the second aspect, wherein
the transmitting unit is provided with a filter (31) which suppresses a component having a frequency ranging from 23.6 to 24.0 GHz of a frequency component included in the short pulse wave output from the burst oscillator.

In order to achieve the above object, according to a twelfth aspect of the present invention, there is provided a UWB short-range radar according to the third aspect, wherein
the transmitting unit is provided with a filter (31) which suppresses a component having a frequency ranging from 23.6 to 24.0 GHz of a frequency component included in the short pulse wave output from the burst oscillator.

In order to achieve the above object, according to a thirteenth aspect of the present invention, there is provided a UWB short-range radar according to the fourth aspect, wherein
the transmitting unit is provided with a filter (31) which suppresses a component having a frequency ranging from 23.6 to 24.0 GHz of a frequency component included in the short pulse wave output from the burst oscillator.

In order to achieve the above object, according to a fourteenth aspect of the present invention, there is provided a UWB short-range radar according to the seventh aspect, wherein
the transmitting unit is provided with a filter (31) which suppresses a component having a frequency ranging from 23.6 to 24.0 GHz of a frequency component included in the short pulse wave output from the burst oscillator.

In order to achieve the above object, according to a fifteenth aspect of the present invention, there is provided a UWB short-range radar according to the first aspect, wherein
the antenna of the transmitting unit has a structure obtained by surrounding an antenna element (123) with a cavity (30), and a resonant frequency of the cavity is caused to fall within a range of 23.6 to 24.0 GHz to reduce gain in the band.

In order to achieve the above object, according to a sixteenth aspect of the present invention, there is provided a UWB short-range radar according to the second aspect, wherein
the antenna of the transmitting unit has a structure obtained by surrounding an antenna element (123) with a cavity (30), and a resonant frequency of the cavity is caused to fall within a range of 23.6 to 24.0 GHz to reduce gain in the band.

In order to achieve the above object, according to a seventeenth aspect of the present invention, there is provided a UWB short-range radar according to the third aspect, wherein
the antenna of the transmitting unit has a structure obtained by surrounding an antenna element (123) with a cavity (30), and a resonant frequency of the cavity is caused to fall within a range of 23.6 to 24.0 GHz to reduce gain in the band.

In order to achieve the above object, according to an eighteenth aspect of the present invention, there is provided a UWB short-range radar according to the fourth aspect, wherein
the antenna of the transmitting unit has a structure obtained by surrounding an antenna element (123) with a cavity (30), and a resonant frequency of the cavity is caused to fall within a range of 23.6 to 24.0 GHz to reduce gain in the band.

In order to achieve the above object, according to a nineteenth aspect of the present invention, there is provided a UWB short-range radar according to the seventh aspect, wherein
the antenna of the transmitting unit has a structure obtained by surrounding an antenna element (123) with a cavity (30), and a resonant frequency of the cavity is caused to fall within a range of 23.6 to 24.0 GHz to reduce gain in the band.

In order to achieve the above object, according to a twentieth aspect of the present invention, there is provided a UWB short-range radar according to the eighth aspect, wherein
the antenna of the transmitting unit has a structure obtained by surrounding an antenna element (123) with a cavity (30), and a resonant frequency of the cavity is caused to fall within a range of 23.6 to 24.0 GHz to reduce gain in the band.

In the UWB short-range radar according to the present invention having the configuration, in response to a pulse signal, a short pulse wave is generated by the burst oscillator which performs an oscillation operation for time corresponding to the pulse width of the pulse signal. For this reason, leakage of a carrier signal does not theoretically occur, an almost entire main lobe can be arranged in a frequency domain which does not overlap an RR radiowave emission prohibited band of 23.6 to 24 GHz in a UWB, so that a UWB short-range radar conforming to the regulations of the FCC can be realized.

In the UWB short-range radar according to the present invention, a filter or an antenna which suppresses a signal in the RR radiowave emission prohibited band is also used as a filter or an antenna in the transmitting unit, so that radiation of a radiowave to the RR radiowave emission prohibited band can be more reliably prevented.

### Brief Description of Drawings

FIG. 1 is a block diagram shown to explain a configuration of a UWB short-range radar according to a first embodiment of the present invention.
FIG. 2 is a block diagram shown to explain a configuration of an example of a burst oscillator for use in a transmitting unit of the UWB short-range radar in FIG. 1.
FIG. 3 is a timing chart shown to explain an operation of the burst oscillator in FIG. 2.
FIG. 4 is a block diagram shown to explain a configuration of another example of the burst oscillator for use in the transmitting unit of the UWB short-range radar in FIG. 1.
FIG. 5 is a block diagram shown to explain a configuration of still another example of the burst oscillator for use in the transmitting unit of the UWB short-range radar in FIG. 1.
FIG. 6 is a graph showing a spectrum power density distribution of a signal output from the burst oscillator in FIG. 1 when a carrier frequency is 26.5 GHz and a pulse width Tp is 1 nS.
FIG. 7 is graph showing damping characteristics of a BRF for use in the transmitting unit of the UWB short-range radar in FIG. 1.
FIG. 8 is a perspective view shown to explain a configuration of a circularly polarizing antenna which is used as a transmitting antenna of the transmitting unit of the UWB short-range radar in FIG. 1.
FIG. 9 is a front view shown to explain the configuration of the circularly polarizing antenna which is used as the transmitting antenna of the transmitting unit of the UWB short-range radar in FIG. 1.
FIG. 10 is a rear view shown to explain the configuration of the circularly polarizing antenna which is used as the transmitting antenna of the transmitting unit of the UWB short-range radar in FIG. 1.
FIG. 11 is an enlarged sectional view taken along the line 11-11 in FIG. 9.
FIG. 12 is an enlarged sectional view taken along the line 12-12 in FIG. 10.
FIG. 13 is a rear view shown to explain a configuration of a sequential rotation array to which the circularly polarizing antenna in FIG. 9 is applied.
FIG. 14 is a graph shown to explain gain characteristics of a circularly polarizing antenna configured to set a resonant frequency of a resonator in an RR radiowave emission prohibited band in the configuration of the sequential rotation array in FIG. 13.
FIG. 15 is a block diagram shown to explain a configuration of an example of a linear multiplier for use in a detecting circuit of a receiving unit of the UWB short-range radar in FIG. 1.
FIG. 16 is a timing chart shown to explain an operation of the linear multiplier in FIG. 15.
FIG. 17 is a principle diagram shown to explain a configuration of a sample-and-hold circuit for use in the receiving unit of the UWB short-range radar.in FIG. 1.
FIG. 18 is a block diagram shown to explain a configuration of still another example of the burst oscillator for use in the transmitting unit of the UWB short-range radar in FIG. 1.
FIG. 19 is a block diagram shown to explain a concrete configuration of the burst oscillator in FIG. 18.
FIG. 20 is a block diagram shown to explain a configuration of still another example of the burst oscillator for use in the transmitting unit of the UWB short-range radar in FIG. 1.
FIG. 21 is a block diagram shown to explain a configuration of a concrete example of the burst oscillator in FIG. 20.
FIG. 22 is a block diagram shown to explain a configuration of still another example of the burst oscillator for use in the transmitting unit of the UWB short-range radar in FIG. 1.
FIG. 23 is a block diagram shown to explain a configuration of a concrete example of the burst oscillator in FIG. 20.
FIG. 24 is a block diagram shown to explain a configuration of a conventional short-range radar.
FIG. 25 is a graph showing a spectrum power density distribution of the conventional short-range radar.
FIG. 26 is a graph shown to explain a spectrum mask regulated by the FCC.

### Best Mode for Carrying Out the Invention

Several embodiments of the present invention will be described below with reference to the accompanying drawings.

### (First Embodiment)

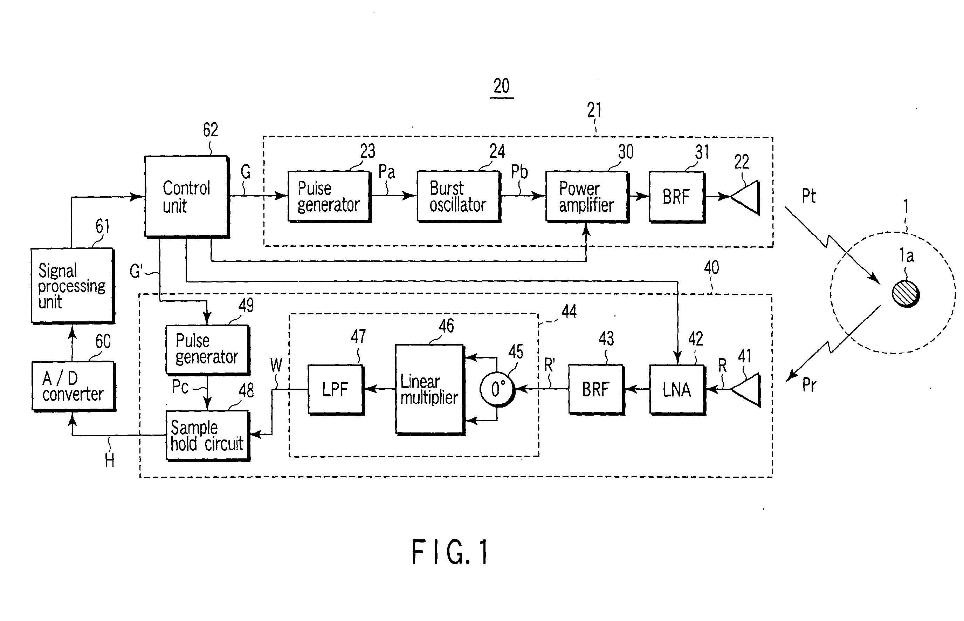

FIG. 1 is a block diagram shown to explain a configuration of a UWB short-range radar 20 according to a first embodiment to which the present invention is applied.

The UWB short-range radar 20 basically includes: a transmitting unit 21 which emits a short pulse wave Pt which satisfies a predetermined spectrum mask from an antenna 22 into a space 1; a receiving unit 40 which receives a reflected wave Pr obtained by an object 1a existing in the space 1 of the short pulse wave Pt emitted by the transmitting unit 21; and a signal processing unit 61 which performs an analyzing process for the object based on a received signal from the receiving unit 40. The transmitting unit 21 has a pulse generator 23 which outputs pulse signals each having a predetermined width at a predetermined frequency, and a burst oscillator 24 which receives the pulse signal output from the pulse generator 23 and performs an oscillation operation for time corresponding to the width of the pulse signal to output a short pulse signal serving as the short pulse wave. A width and a cycle of the pulse signal output from the pulse generator and an oscillation frequency of the short pulse signal output from the burst oscillator are set such that an almost entire main lobe of a spectrum of the short pulse wave emitted from the antenna into the space falls within a range of 24.0 to 29.0 GHz in the predetermined spectrum mask and that a radiation power density to an RR radiowave emission prohibited band held by the predetermined spectrum mask is lower than a peak radiation power density of the main lobe by not less than 20 dB.

The UWB short-range radar 20 is, more specifically, constituted by the transmitting unit 21, the receiving unit 40, an analog/digital (A/D) converter 60, the signal processing unit 61, and a control unit 62.

The transmitting unit 21 is configured to generate a short pulse wave (burst wave) Pt having a predetermined width Tp (for example, 1 ns) and a predetermined carrier frequency Fc (for example, 26 GHz) each time the transmitting unit 21 receives, for example, a transmission trigger signal G output at a predetermined frequency and to emit the short pulse wave Pt from the antenna 22 into the space 1.

The transmitting unit 21, as shown in FIG. 1, has, in addition to the antenna 22, the pulse generator 23 which generates a pulse signal Pa having a width Tp (for example, 1 nS) in synchronism with a timing at which a level of the transmission trigger signal G transits in a predetermined direction (for example, a rising direction) and the burst oscillator 24 which oscillation-outputs the short pulse (burst signal) Pb having a carrier frequency Fc in only time Tp (only time Tp corresponding to a pulse width) in which the pulse signal Pa is received from the pulse generator 23.

In this case, various configurations can be conceived as the burst oscillator 24.

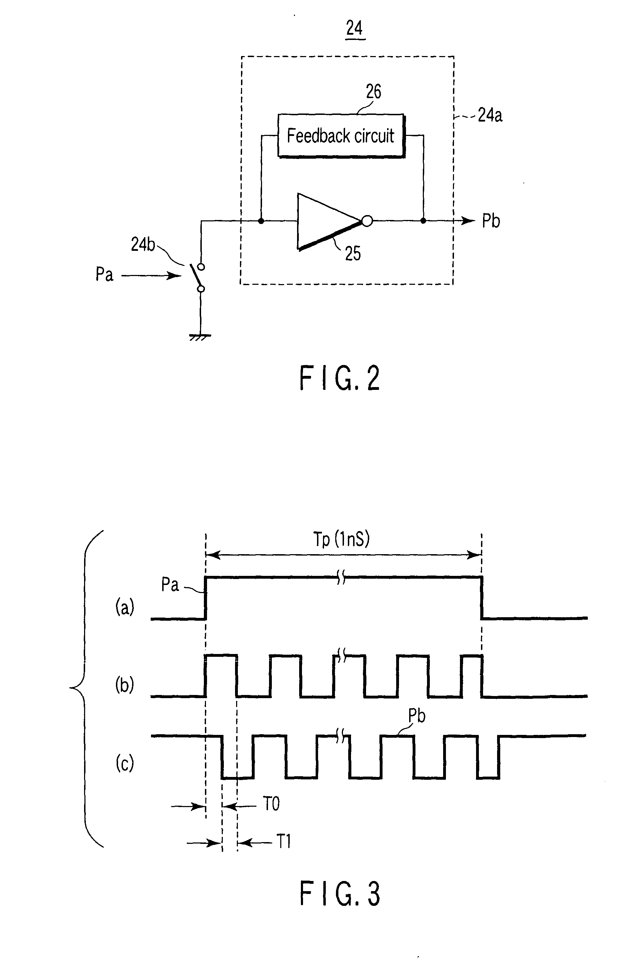

For example, like the burst oscillator 24 shown in FIG. 2, a burst oscillator is constituted by an oscillation unit 24a, an inverter (signal inverter) 25, and a feedback circuit 26 which delays an output signal from the inverter 25 by predetermined time (T1) to feed back the delayed signal to an input terminal. The burst oscillator is configured to switch an operation state of the oscillation unit 24a to any one of an oscillation state and an oscillation stop state by a switch circuit 24b which is opened or closed by the pulse signal Pa.

The feedback circuit 26 is constituted by an L-shaped low-pass filter (LPF), a T-shaped low-pass filter (LPF), or the like composed of, for example, a resistor (or coil) and a capacitor.

The switch circuit 24b is inserted to open or close a circuit between an input terminal (may be an output terminal) of the inverter 25 and a ground line. As shown in (a) of FIG. 3, the switch circuit 24b is constituted by an electronic switch constituted by a semiconductor device such that the switch circuit 24b is set in a closed state when the pulse signal Pa is at a low level (pulse non-input state) and set in an open state when the pulse signal Pa is at a high level (pulse input state).

While the switch circuit 24b is closed, an output from the inverter 25 is at a high level, and an output from the feedback circuit 26 is also originally at a high level. However, the feedback circuit 26 is forcibly fixed to a low level by the switch circuit 24b.

When the switch circuit 24b, an original high-level output from the feedback circuit 26 is input to the inverter 25 without being delayed as shown in (b) of FIG. 3.

When response delay time T0 of inputting/outputting of the inverter 25 has elapsed, the output from the inverter 25 goes to low level as shown in (c) of FIG. 3.

When delay time T1 of the feedback circuit 26 has elapsed after the response delay time T0 has elapsed, an input to the inverter 25 goes to low level as shown in (b) of FIG. 3.

When the response delay time T0 has further elapsed after the delay time T1 has elapsed, the output from the inverter 25 goes to high level as shown in (c) of FIG. 3.

The operations are repeated while the switch circuit 24b is opened, and the oscillation unit 24a oscillation-outputs a rectangular wave having a frequency of 1/2(T0+T1) in the form of a burst. When the switch circuit 24b is closed, the oscillation operation of the oscillation unit 24a is stopped.

A time constant (delay time) of the feedback circuit 26 is set such that the frequency 1/2(T0+T1) of the short pulse Pb is, for example, 26.5 GHz.

Since the transmitting unit 21 is configured to control the oscillation operation itself of the burst oscillator 24 by the pulse signal Pa, carrier leakage does not theoretically occur.

Therefore, restriction of a power density regulated in use of a UWB may be performed in consideration of only an instantaneous power of a short pulse wave which is output in oscillation. A power regulated by a spectrum mask of the UWB can be maximally effectively used.

Since no carrier leakage occurs, a main lobe can be arranged at an arbitrary position on the spectrum mask of the UWB. An almost entire area of the main lobe can be prevented from overlapping the RR radiowave emission prohibited band.

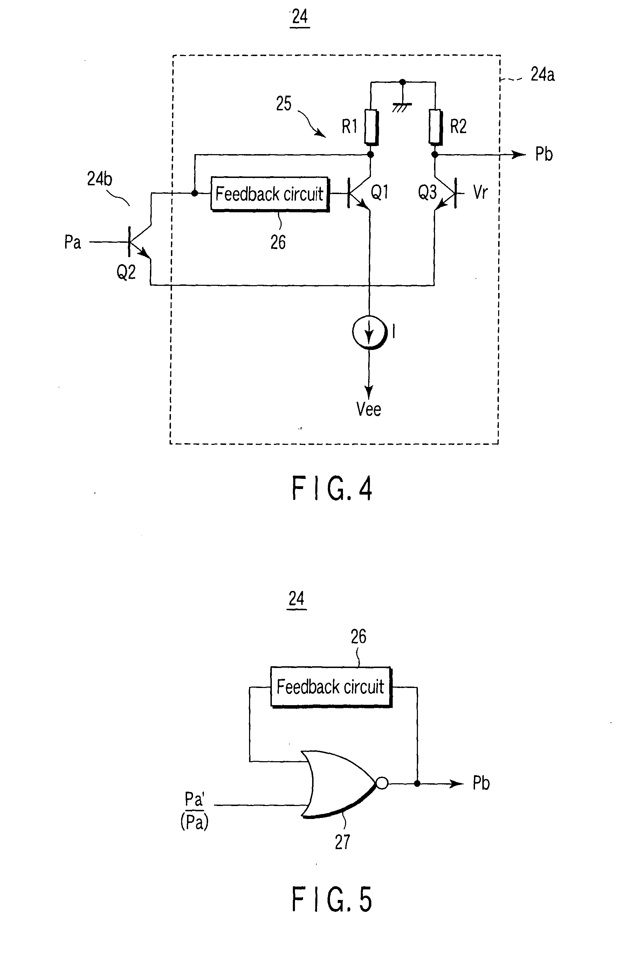

The inverter 25 and the switch circuit 24b, as shown in FIG. 4, can be constituted by transistors.

More specifically, the inverter 25 is constituted by a transistor Q1 and a load resistor R1. The feedback circuit 26 is connected between a collector of the output terminal of the inverter 25 and a base of the input terminal of the inverter 25.

The switch circuit 24b is constituted by a transistor Q2. While a pulse signal Pa to be input to a base of the transistor Q2 is at a high level, a collector and an emitter are electrically conductive, and an output level of the transistor Q1 is forcibly fixed to a low level to stop the oscillation operation of the oscillation unit 24a.

When the pulse signal Pa goes to low level, the transistor Q2 is turned off. For this reason, the oscillation operation of the oscillation unit 24a is activated by the transistor Q1 and the feedback circuit 26.

In FIG. 4, a transistor Q3 and a load resistor R2 are circuits to output an oscillation signal, and are configured to compare an oscillation signal voltage appearing at the emitter of the transistor Q1 with a reference voltage Vr input to the base in size to output the comparison result from a collector side.

In FIG. 4, an element added with a reference symbol I is a current source.

FIG. 5 shows an example of the burst oscillator 24 in which the inverter 25 and the switch circuit 24b are constituted by a NOR circuit 27.

In the burst oscillator 24 having the configuration, in contrast to the above case, a pulse signal Pa' having a negative logic is used. When the pulse signal Pa' is at a high level (pulse non-input period), an output from the NOR circuit 27 is forcibly fixed to a low level to set an oscillation stop state. While the pulse signal Pa is at a low level (pulse input period), the NOR circuit 27 is made to function as an inverter for the feedback circuit 26 to set an oscillation state.

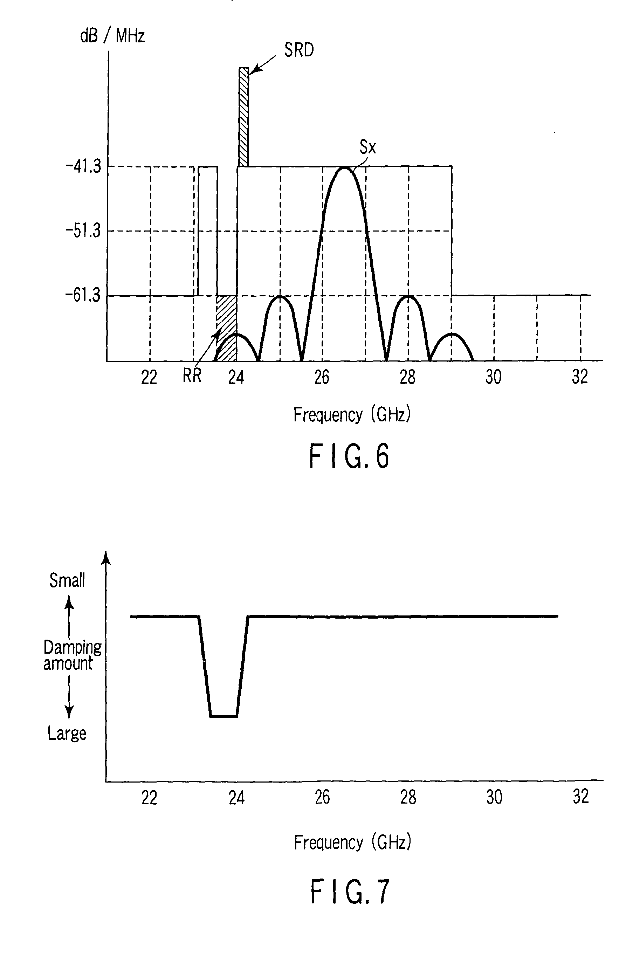

FIG. 6 shows a spectrum power density distribution Sx of a signal Pb output from the burst oscillator 24 when a carrier frequency and a pulse width Tp are 26.5 GHz and 1 nS, respectively. Both the ends (frequencies at which an output power is theoretically zero) of the main lobe having the spectrum distribution Sx are 26.5 ± 1 GHz.

In general, when a pulse width and a center frequency are represented by and fc, respectively, both the ends of the main lobe having the spectrum distribution Sx are expressed by fc ± 1/τ.

Therefore, the main lobe does not overlap the RR radiowave emission prohibited band of 23.6 to 24 GHz.

Side lobes at both the sides of the main lobe overlap the RR radiowave emission prohibited band. However, in general, the levels of the side lobes are considerably lower than that of the main lobe, and thus, the side lobes do not any problem.

As will be described later, a component of the RR radiowave emission prohibited band can be suppressed by a BRF 31 and the transmitting antenna 22.

In FIG. 6, the entire main lobe of the spectrum of the short pulse wave Pt is set in an area higher than the RR radiowave emission prohibited band in the UWB. However, this does not limit the present invention. The width and cycle of the pulse signal Pa and the oscillation frequency of the burst oscillator 24 may be set such that almost an entire area of the main lobe is set in the range of 24.0 to 29 GHz.

In this case, as the almost entire area of the main lobe, for example, a range of a peak of the spectrum Sx to -20 dB can be considered as one reference. The peak at this time is -41.3 dBm/MHz, a lower level of the main lobe is always a specified level, i.e., -61.3 dB/MHz or less, of the RR radiowave emission prohibited band to satisfy a specified mask.

However, when the level of the side lobe exceeds -61.3 dB/MHz in the RR radiowave emission prohibited band, the level may be attenuated by a notch function of the BRF 31 (will be described later) or the transmitting antenna 22.

The short pulse (burst signal) Pb output from the burst oscillator 24 is amplified to a specified power by a power amplifier 30 and supplied to the transmitting antenna 22 through the BRF 31. A short pulse wave Pt is emitted from the transmitting antenna 22 into the space 1 serving as an exploration target.

In this case, the band rejection filter (BRF) 31 which suppresses out-of-band unnecessary emission to an output signal from the inverter 25, for example, as shown in FIG. 7, is a notch filter having large damping characteristics to the RR radiowave emission prohibited band of 23.6 to 24 GHz. The BRF 31 further reduces a level of emission to the RR radiowave emission prohibited band.

A gain of the power amplifier 30 is configured so as to be varied by the control unit 62 (will be described later).

The transmitting antenna 22 which emits the short pulse wave Pt into the space 1 requires wideband characteristics in order to effectively emit the short pulse wave Pt of the UWB into the space.

In this embodiment, a circularly polarizing antenna using a spiral element is used as an antenna which can be used in a wideband in a UWB.

As a matter of course, in place of the circularly polarizing antenna, a linear polarizing antenna using a bow tie antenna or the like as an element can also be used.

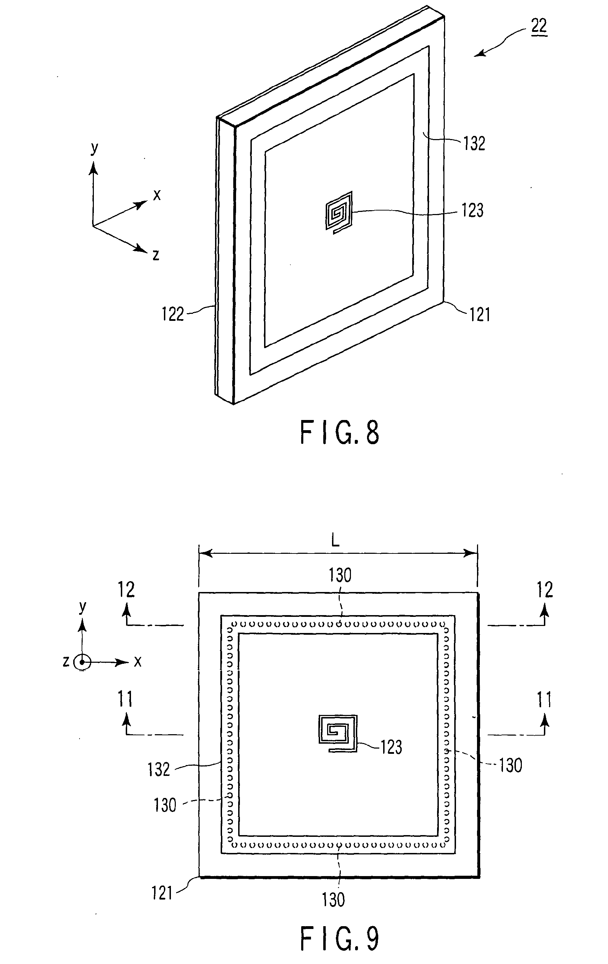

FIGS. 8 to 12 show basic structures of the transmitting antenna 22.

The transmitting antenna 22 has, for example, a dielectric substrate 121 having a thickness of 1.2 mm and made of a substrate material having a low dielectric constant (about 3.5), a grounding conductor 122 formed on one surface side (rear surface sides in FIGS. 8 and 9) of the dielectric substrate 121, an unbalanced antenna element 123 having a right-hand rectangular spiral formed as a pattern on an opposite surface side (front surface sides in FIGS. 8 and 9) of the dielectric substrate 121, and a feeding pin 125 which has one end connected to an end portion (feeding point) of the antenna element 123 on a spiral center side and penetrates the dielectric substrate 121 in a direction of depth of the dielectric substrate 121 to pass through a hole 122a of the grounding conductor 122.

Electricity is supplied from the other-end side of the feeding pin 125 to the transmitting antenna 22 by an unbalanced feed line, for example, a coaxial cable, a coplanar line using the grounding conductor 122 as a ground line, a microstrip line (will be described later), or the like to make it possible to emit a counterclockwise circularly-polarized radiowave from the antenna element 123.

However, in the antenna having such a structure, a surface wave along the surface of the dielectric substrate 121 is excited to make it impossible to obtain desired characteristics due to the influence of the surface wave in some cases.

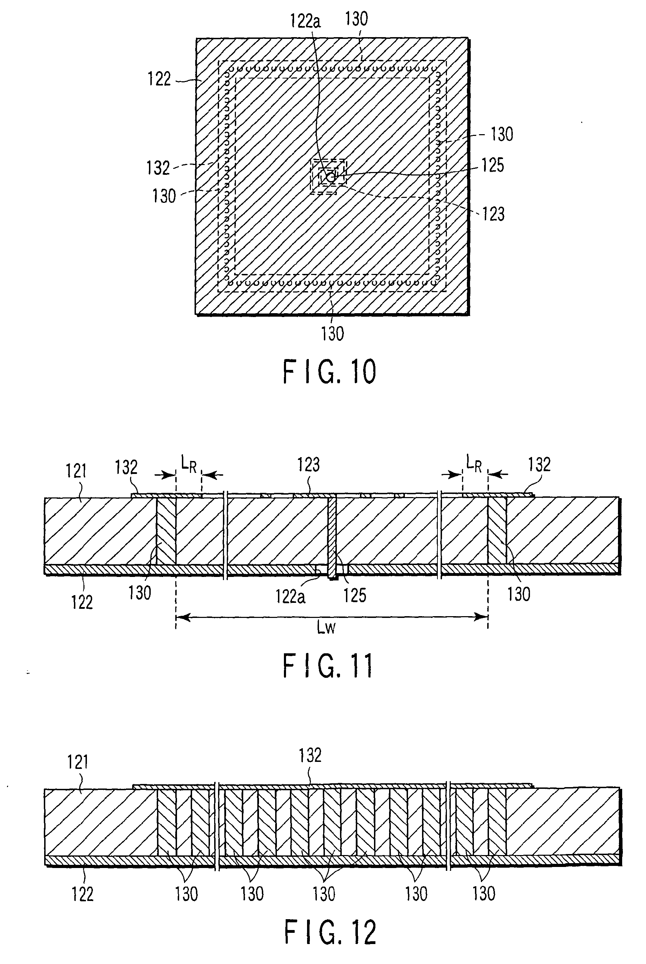

Therefore, in the transmitting antenna 22 according to the embodiment, as shown in FIGS. 11 and 12, columnar metal posts 130 each having a one-end side which is connected to the grounding conductor 122 to penetrate the dielectric substrate 121 and each having the other-end side which extends to the opposite surface of the dielectric substrate 121 are arranged at predetermined intervals so as to surround the antenna element 123 to constitute a cavity structure. Furthermore, on the opposite surface of the dielectric substrate 121, the other-end sides of the metal posts 130 are sequentially short-circuited along a direction in which the metal posts 130 are arrayed, and a frame-shaped conductor 132 extending from the connection positions between the frame-shaped conductor 132 and the metal posts 130 to the antenna element 123 is arranged to suppress a surface wave.

A distance (to be referred to as a rim width hereinafter) extending from an inner wall of a cavity of the frame-shaped conductor 132 to an inside of the frame-shaped conductor 132 is represented by L_{R}, the distance L_{R} corresponds to about 1/4 of a propagating wavelength of a radiowave in the cavity.

The metal post 130 is realized by, for example, plating (through hole plating) an inner wall of a hole penetrating the dielectric substrate 121.

The cavity having the frame-shaped conductor 132 is spirally excited to suppress a surface wave, so that a circularly polarizing antenna having directivity which is good in symmetry throughout a wideband can be obtained.

Even though the cavity is excited by a linear polarizing antenna element such as a bow tie antenna, a linear polarizing antenna having wideband characteristics similar to wideband characteristics of circularly polarization can be obtained.

The transmitting antenna 22 can be singularly used in various UWB communication systems. However, when a gain required for a UWB radar is short, or when a beam must be narrowed down, the antennas 22 may be arrayed.

When circularly polarizing antennas are arrayed, a sequential rotation array which suppresses a cross-polarized wave to make it possible to improve polarizing characteristics of the antennas as a whole can be employed.

The sequential rotation array, as disclosed in the following Non-patent Document 2, is an array antenna in which a plurality (N) of same antenna elements are arranged on the same plane. In the array antenna, the antenna elements are arranged such that the antenna elements are sequentially rotated every p·π/N radian about an axis in a radial direction, and feeding phases to the respective antenna elements are caused to transit every p·π/N radian depending on an arrangement angle of the antenna elements.

In this case, reference symbol p is an integer number which is 1 or more and N-1 or less.

Non-patent Document 2: T. Teshirogi et al., Wideband Circularlyly Polarized Array Antenna with Sequential Rotation and Phase Shift of Elements, ISAP-85, 024-3, pp. 117 to 120, 1985

With this structure, a cross-polarized wave component in the entire antenna is canceled and almost complete circularly polarizing characteristics can be obtained even though polarizing characteristics of the respective antenna elements are incomplete circularly-polarized wave (more specifically, elliptically-polarized wave).

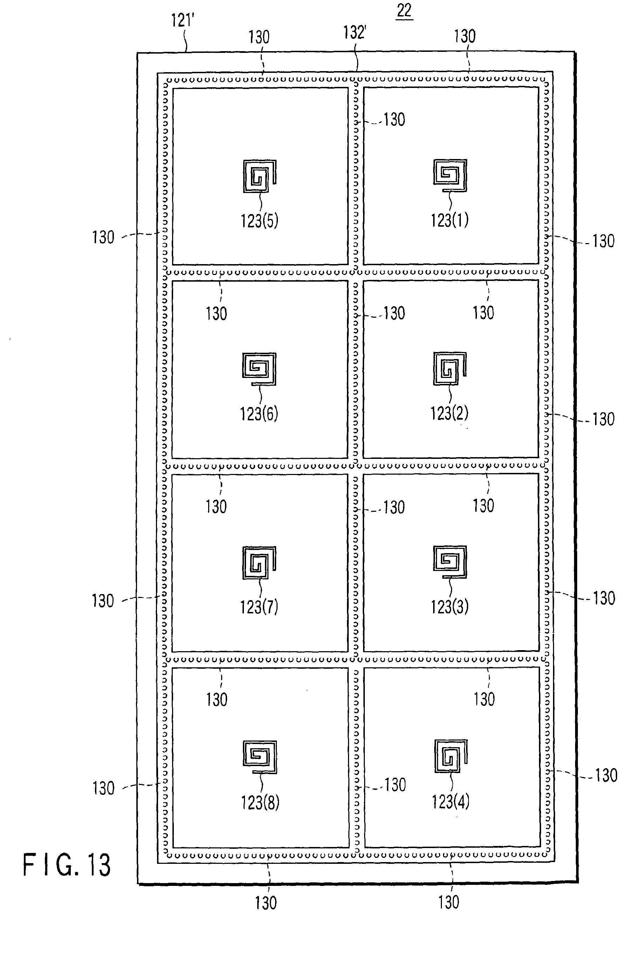

FIG. 13 shows a configuration of the transmitting antenna 22 in which antenna elements are arrayed by using the above principle.

The transmitting antenna 22 is structured such that the antenna elements 123 are arrayed in 2 columns and 4 stages on a vertically-long rectangular common dielectric substrate 121' and a grounding conductor (not shown).

On the grounding conductor side of the transmitting antenna 22, a feeding unit (not shown) to distributionally feed an exciting signal to the plurality of antenna elements is formed.

On a surface of the dielectric substrate 121', eight antenna elements 123(1) to 123(8) each formed in the form of a right-hand rectangular spiral as in the above embodiment are arranged in 2 columns and 4 stages.

The antenna elements 123 (1) to 123(8) are surrounded by a cavity formed by arranging the metal posts 130 the one-end sides of which are connected to the grounding conductor. Furthermore, the other-end sides of the metal posts 130 are connected along the direction of arrangement of the metal posts 130 by a frame-shaped conductor 132' extending from the connection positions between the antenna elements 123(1) to 123(8) and the metal posts 130 to the antenna elements 123 by a predetermined distance (corresponding to the rim width L_{R}), so that a surface wave is suppressed from being generated every antenna element.

In the transmitting antenna 22, the cavity constituted by the metal posts 130 and the frame-shaped conductor 132' are arranged on the dielectric substrate to constitute a resonator, and the resonator may be excited by circularly polarizing antenna elements.

Since the transmitting antenna 22 is a resonator, the transmitting antenna 22 has a resonant frequency. At the frequency, an input impedance of the antenna becomes vary high to prevent emission.

The resonant frequency is determined by structural parameters of the resonator and the circularly polarizing antenna elements.

Consequently, frequency characteristics of an antenna gain are suddenly deeply notched near the resonant frequency.

When the resonant frequency is adjusted to, for example, the RR radiowave prohibited band (23.6 to 24.0 GHz), interference to an earth exploration satellite can be considerably reduced.

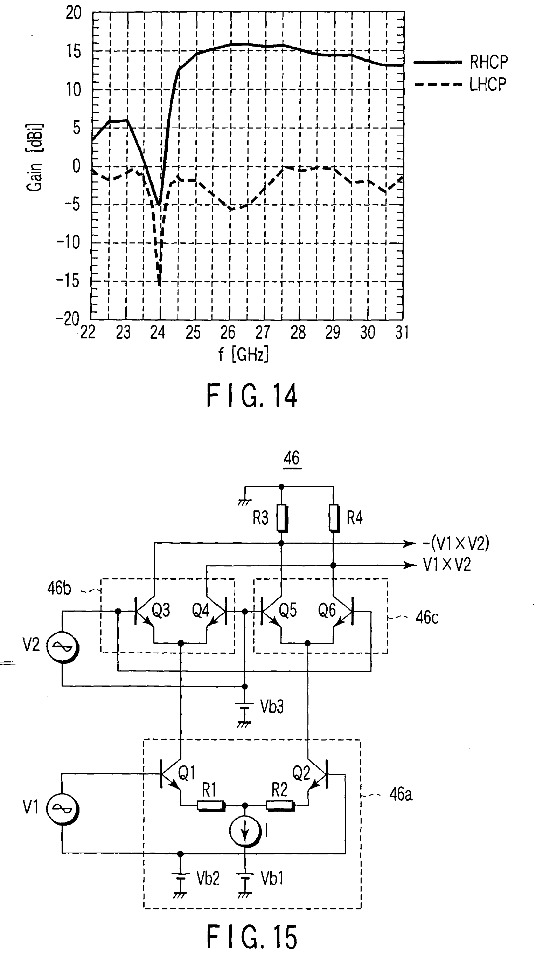

FIG. 14 shows a result obtained by measuring frequency characteristics of gains of a right-hand circularly-polarized component (RHCP) of a main polarized wave of an antenna which has the configuration shown in FIG. 13 and which is experimentally manufactured and a left-hand circularly-polarized component (LHCP) of a cross-polarized wave.

In this example, the main polarized wave component has a gain of 13 dBi or more throughout a range of 24.5 to 31 GHz. It is understood that a sharp notch which drops from a peak level by about 20 dB occurs in the RR radiowave prohibited band.

A structural parameter of any one or both of the resonator and the spiral antenna element is appropriately selected to make it possible to easily match a frequency at which a notch occurs to the RR radiowave prohibited band described above.

Therefore, when the notch frequency is used in accordance with the RR radiowave prohibited band, and when the burst oscillator 24 free from the carrier leakage described above and the BRF 31 having a notch frequency in the RR radiowave prohibited band are employed, a radiation level of a radiowave to the RR radiowave prohibited band can be easily reduced by 20 dB or more. A spectrum mask obtained by new regulations by the FCC can be satisfied.

A short pulse wave Pt output from the transmitting antenna 22 having the above configuration into the space 1 is reflected by the object 1a existing in the space 1, and the reflected wave Pr is received by the receiving antenna 41 of the receiving unit 40.

The receiving antenna 41 has the same configuration as that of the transmitting antenna 22.

However, a circularly-polarized radiowave has a property in which a polarizing rotation direction is reversed by reflection. For this reason, the polarized rotation directions of the transmitting antenna and the receiving antenna are made opposite to each other, so that a secondary reflecting component (more strictly speaking, an even-number-order reflecting component) is suppressed to make it possible to make selectivity to a primary reflecting component (more strictly speaking, an odd-number-order reflecting component).

As a result, in the short-range radar, a false image generated by secondary reflection can be reduced.

A receiving signal R output from the receiving antenna 41 having received the reflected wave Pr is amplified by an low-noise amplifier (LNA) 42, and then, band-limited by a band-pass filter (BPF) 43 having a bandwidth of about 2 GHz.

A band-limited reflected signal R' is detected by the detecting circuit 44.

A gain of the LNA 42 is configured so as to be varied by the control unit 62.

The detecting circuit 44 is constituted by a branch circuit 45 which branches the reflected signal R' output from the BPF 43 in a common mode (0°), a linear multiplier 46 which linearly multiplies reflected signals branched in the common mode, and a low-pass filter (LPF) 47 which extracts a baseband component W from an output signal from the linear multiplier 46.

The linear multiplier 46 includes several schemes such as a scheme using a double balancing mixer. As a linear multiplier operating at a high speed, a method of constructing a linear multiplier by using a gilbert mixer is conceived.

The gilbert mixer is, as shown in FIG. 15, constituted by three differential amplifiers 46a, 46b and 46c.

A first signal V1 is differentially input to the differential amplifier 46a, and a second signal V2 is differentially input to the two differential amplifiers 46b and 46c connected to the load side of the differential amplifier 46a. In this case, only a signal component equal to a product of the first signal V1 and the second signal V2 is output from load resistors R3 and R4.

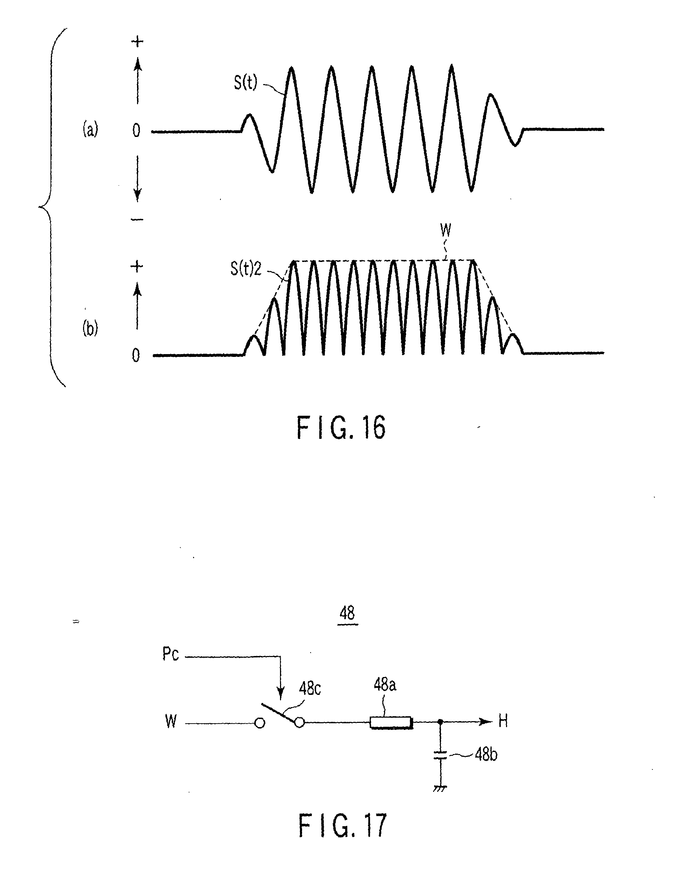

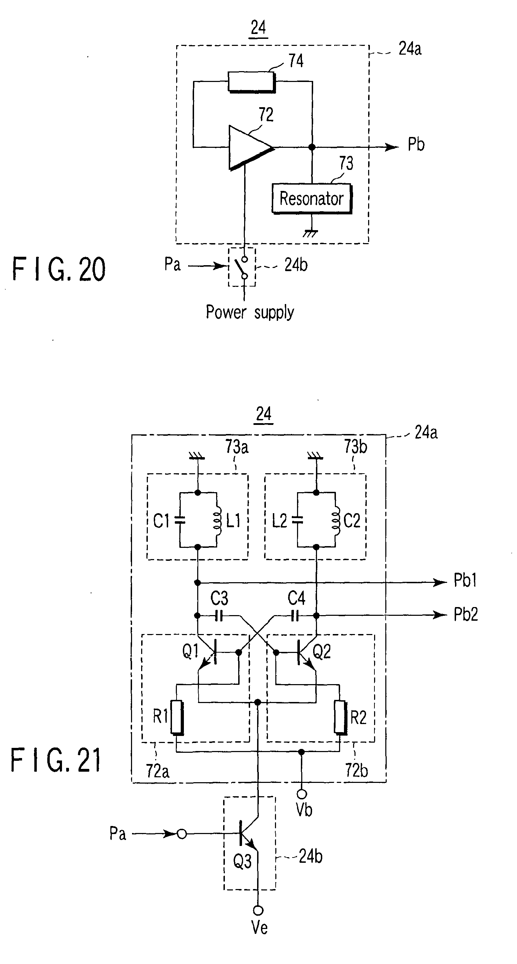

When a sinusoidal signal S(t), for example, as shown in (a) of FIG. 16 is input to the linear multiplier 46 having the configuration in a common phase like burst, an output signal from the linear multiplier 46 has a waveform obtained by squaring an input signal S(t) as shown in (b) of FIG. 20. An envelope curve (baseband) W of the waveform is in proportion to a power of the input signal S(t).

The linear multiplier 46 constituted by the plurality of differential amplifiers can be structured by a monolithic microwave integrated circuit (MMIC) to have a very small size. In addition, since a local signal need not be supplied to the linear multiplier 46, the linear multiplier 46 requires a low power consumption.

The baseband signal W obtained by the detecting circuit 44 is input to the sample hold circuit 48.

The sample hold circuit 48, as shown in FIG. 17 as a principle diagram, has a configuration in which the baseband signal W is input to an integration circuit constituted by a resistor 48a and a capacitor 48b through a switch 48c.

The sample hold circuit 48 closes the switch 48c to integrate the baseband signal W while a pulse signal Pc from a pulse generator 49 is at a high level (or low level). When the pulse signal Pc goes to low level, the sample hold circuit 48 opens the switch 48c to hold an integration result.

The pulse generator 49 generates the pulse signal Pc having a predetermined width Tc each time a reception trigger signal G' output behind the transmission trigger signal G is received, and outputs the pulse signal Pc to the sample hold circuit 48.

Therefore, the receiving unit 40 performs a detecting process to the reflected wave Pr received from when the reception trigger signal G' is received to when predetermined time Tc has elapsed.

Although not shown, the width Tc of the pulse signal Pc is configured so as to be varied by the control unit 62.

A signal H integrated and held by the sample hold circuit 48 is converted into a digital value by the A/D converter 60 immediately after the signal H is held and input to the signal processing unit 61.

The signal processing unit 61 analyzes the object 1a existing in the space 1 based on the signal H obtained by the receiving unit 40 and notifies a user of the analysis result by an output device (not shown) (for example, a display unit or a voice generator) or notifies the control unit 62 of information required for control.

The control unit 62 performs various controls (variable control or the like of delay time between the trigger signals G and G') for the transmitting unit 21 and the receiving unit 40 according to a predetermined schedule about the signal processing unit 61 or depending on a processing result of the signal processing unit 61 to cause the short-range radar 20 to perform exploration of a desired distance area.

In the UWB short-range radar 20 described above, a configuration in which an output from the inverter is delay-fed back to the input to perform oscillation is employed as the burst oscillator 24.

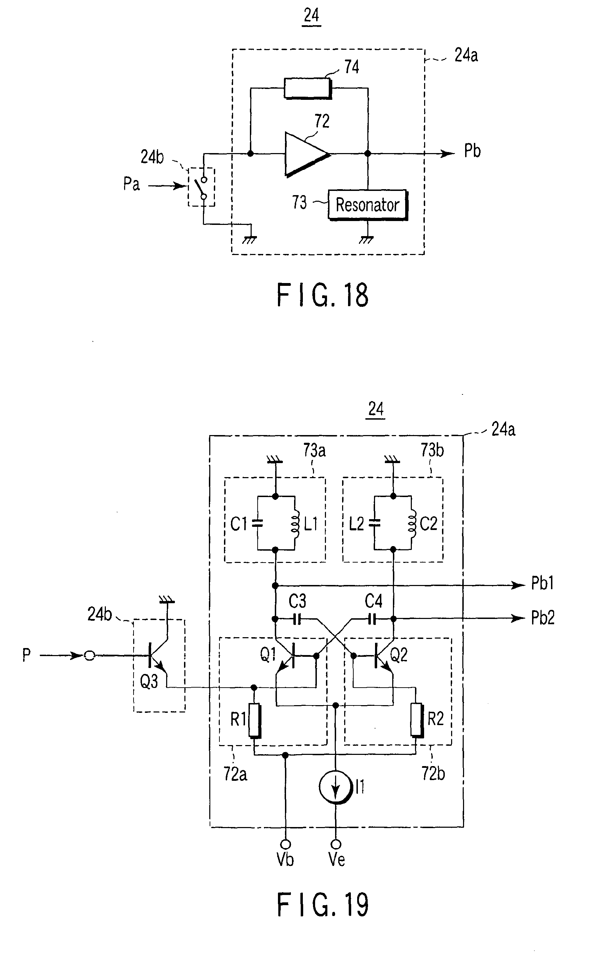

However, as in the oscillation unit 24a of the burst oscillator 24 shown in FIG. 18, a configuration can also be employed in which an output from an amplifier 72 using a resonator 73 as a load is positively fed back to the input side of the amplifier 72 by a feedback circuit 74 to perform oscillation.

In this case, a circuit between an input terminal or an output terminal of the amplifier 72 and a ground line is opened or closed by the switch circuit 24b as in the above description, so that the oscillation unit 24a is switched to an oscillation operation state and an oscillation stop state.

FIG. 19 shows a more concrete circuit of the burst oscillator 24 in FIG. 18.

In FIG. 19, the oscillation unit 24a has: a resonator 73a formed by connecting a coil L1 and a capacitor C1 in parallel to each other; a amplifier 72a constituted by a transistor Q1 using the resonator 73a as a load and a base resistor R1; a resonator 73b formed by connecting a coil L2 and a capacitor C2 in parallel to each other; and an amplifier 72b constituted by a transistor Q2 using the resonator 73b as a load and a base resistor R2.

A collector (output of the amplifier 72a) of the transistor Q1 and a base (input of the amplifier 72b) of the transistor Q2 are connected to each other through a capacitor C3.

A collector (output of the amplifier 72b) of the transistor Q2 and a base (input of the amplifier 72a) of the transistor Q1 are connected to each other through a capacitor C4.

Furthermore, emitters of both the transistors Q1 and Q2 are connected to a negative power supply Ve through a constant current source I1.

The base resistors R1 and R2 of both the transistors Q1 and Q2 are connected to a bias power supply Vb.

The oscillation unit 24a continues an oscillation operation by alternately turning on/off the transistors Q1 and Q2. For this reason, when the amplifier 72a which is one of the two amplifiers is used as a main amplifier, the amplifier 72b which is the other of the two transistors constitutes the feedback circuit 74 which inversely amplifies an output from the amplifier 72a by the amplifier 72b to positively feedback the output to the input side of the amplifier 72a.

When the amplifiers are regarded as one common-phase amplifier in which the amplifier 72a and the amplifier 72b as a pre-stage and a post-stage, respectively, the capacitor C4 which feeds back a signal from the post-stage amplifier 72b to the pre-stage amplifier 72a constitutes the feedback circuit 74.

In any case, the oscillation unit 24a can be regarded as an oscillation unit constituted by a resonator, an amplifier, and a feedback circuit.

In the oscillation unit 24a having the configuration, two-phase burst oscillation signals Pb1 and Pb2 the phases of which are inverted can be output.

On the other hand, the switch circuit 24b is constituted by the transistor Q3, the collector of the transistor Q3 is connected to a ground line, and an emitter is connected to a base of the transistor Q1 (or the other transistor Q2) of the amplifier 72a.

When a pulse signal P received by the base of the pulse generator 3 is at a low level, a state between the collector and the emitter is set to be an open state, and a positive feedback loop is maintained to set the oscillation unit 24a in an oscillation state. When a pulse signal P is at a high level, a state between the collector and the emitter is set to be a closed state, so that the oscillation unit 24a is set in an oscillation stop state to prevent positive feedback from being performed.

In the example of the burst oscillator, the circuit between the input side of the amplifier 72 and the ground line is closed by the switch circuit 24b to prevent positive feedback from being performed.

However, the switch circuit 24b may be connected between the output side of the amplifier 72 and the ground line, i.e., in parallel to the resonator 73.

In this case, when the switch circuit 24b is closed by the pulse signal Pa to connect the output side of the amplifier 72 to the ground line (the resonator 73 is short-circuited), positive feedback to the input side of the amplifier 72 is not performed as in the above description, and the oscillation unit 24a is set in an oscillation stop state.

In the above circuit, the positive feedback loop is connected to the ground line to prevent positive feedback from being performed.

However, in the oscillation unit 24a having the two resonators 73a and 73b, it is one of oscillation conditions that the resonant frequencies of both the resonators 73a and 73b are equal to each other. For this reason, the resonant frequency of one of the resonators is switched to a frequency considerably different from a desired oscillation frequency to make it possible to prevent positive feedback from being performed.

In the above embodiments, positive feedback to the input side of the amplifier 72 is sufficiently prevented from being performed to set an oscillation stop state, and the amplifier 72 is stationarily set in an active state. For this reason, an oscillation signal depending on a level of a pulse signal can be intermittently output without leakage while keeping high-speed response to switching of the switch circuit 24b.

As in the burst oscillator 24 shown in FIG. 20, the switch circuit 24b is connected to a power supply line of the amplifier 72 of the burst oscillator 24, and power supply to the amplifier 72 (including a bias power supply) is regulated to also make it possible to stop the oscillation operation.

More specifically, as shown in FIG. 21, the switch circuit 24b constituted by the transistor Q3 is used in place of the constant current source I1 to turn on/off the transistor Q3 by the pulse signal P. As a consequence, the oscillation unit 24a is switched between the oscillation state and the oscillation stop state to intermittently output an oscillation signal.

Although not shown, supply of the bias power supply Vb may be regulated by the switch circuit 24b to intermittently output an oscillation signal.

In the configuration in which the power supply to the amplifier 72 is controlled as described above to generate a burst wave, an oscillation operation may not be started immediately after the power is supplied.

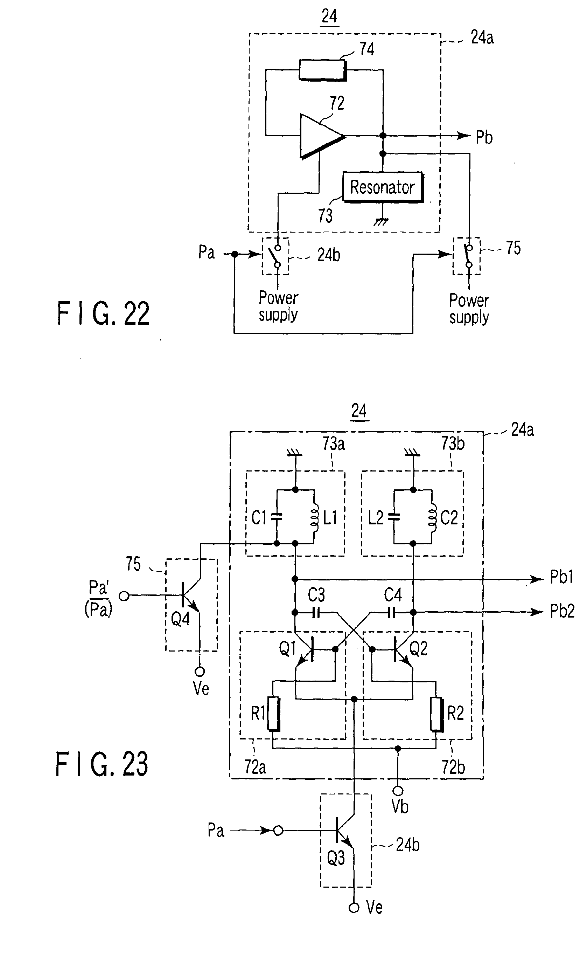

In this case, as in the burst oscillator 24 shown in FIG. 22, a switch circuit 75 which performs a reverse operation of the operation of the switch circuit 24b is used. The switch circuit 75 is closed in only a period in which the power supply to the amplifier 72 is stopped to cause a predetermined current to flow into the resonator 73.

The switch circuit 75 is opened at a timing at which the switch circuit 24b is closed to supply a power, and a signal having a resonant frequency and generated by a transient phenomenon is generated from the resonator 73 to shift the oscillation unit 24a to the oscillation state without delay.

FIG. 23 shows a more concrete exemplary circuit of the burst oscillator 24 in FIG. 22.

More specifically, in the exemplary circuit, a circuit between the resonator 73a which is one of (or both of) the resonators and the amplifier 72a and the power supply Ve is opened or closed by the switch circuit 75 constituted by a transistor Q4.

To a base of the transistor Q4, a signal Pa' obtained by inverting the pulse signal Pa is supplied.

In each of the resonant burst oscillators 24 described above, the resonator 73 may be constituted by not only an LC type resonator but also a transmission-line type (for example, λ/4 type) resonator.

Therefore, according to the present invention described above, the problems of the prior art are solved, a scheme which does not occur leakage of a carrier signal in a UWB is realized. Consequently, it is possible to provide a UWB short-range radar which prevents an RR radiowave prohibited band and an SRD band from being hindered while conforming to a spectrum mask regulated as a UWB radar.

## Claims

1. A UWB short-range radar **characterized by** comprising:
a transmitting unit which emits a short pulse wave which satisfies a predetermined spectrum mask from an antenna into space;
a receiving unit which receives a reflected wave produced by an object existing in space of the short pulse wave emitted by the transmitting unit; and
a signal processing unit which performs an analyzing process for the object based on an output signal from the receiving unit,
wherein
the transmitting unit has:
a pulse generator which outputs pulse signals each having a predetermined width at a predetermined frequency; and
a burst oscillator which receives the pulse signal output from the pulse generator and performs an oscillation operation for a time corresponding to the width of the pulse signal to output a short pulse signal serving as the short pulse wave, and
a width and a cycle of the pulse signal output from the pulse generator and an oscillation frequency of the short pulse signal output from the burst oscillator are set such that almost an entire main lobe of a spectrum of the short pulse wave emitted from the antenna into space falls within a range of 24.0 to 29.0 GHz in the predetermined spectrum mask, and that a radiation power density to an RR radiowave emission prohibited band held by the predetermined spectrum mask is lower than a peak radiation power density of the main lobe by not less than 20 dB.

2. The UWB short-range radar according to claim 1, **characterized in that**
both ends of the main lobe of the spectrum of the short pulse wave output from the burst oscillator fall within a range of 24.0 to 29.0 GHz in the predetermined spectrum mask.

3. The UWB short-range radar according to claim 1, **characterized in that**
a side lobe on a low-frequency side of the main lobe of the spectrum of the short pulse wave output from the burst oscillator overlaps the RR radiowave emission prohibited band held by the predetermined spectrum mask.

4. The UWB short-range radar according to claim 1, **characterized in that**
the burst oscillator is constituted by:
an oscillation unit comprising a signal inverter and a feedback circuit which delays an output signal from the signal inverter to feed back to an input terminal, the oscillation unit performing oscillation at a frequency determined by input/output response time of the signal inverter and delay time of the feedback circuit; and
a switch circuit which sets the oscillation unit in an oscillation state only in a period in which the pulse signal output from the pulse generator is received.

5. The UWB short-range radar according to claim 2, **characterized in that**
the burst oscillator is constituted by:
an oscillation unit comprising a signal inverter and a feedback circuit which delays an output signal from the signal inverter to feed back to an input terminal, the oscillation unit performing oscillation at a frequency determined by input/output response time of the signal inverter and delay time of the feedback circuit; and
a switch circuit which sets the oscillation unit in an oscillation state only in a period in which the pulse signal output from the pulse generator is received.

6. The UWB short-range radar according to claim 3, **characterized in that**
the burst oscillator is constituted by:
an oscillation unit comprising a signal inverter and a feedback circuit which delays an output signal from the signal inverter to feed back to an input terminal, the oscillation unit performing oscillation at a frequency determined by input/output response time of the signal inverter and delay time of the feedback circuit; and
a switch circuit which sets the oscillation unit in an oscillation state only in a period in which the pulse signal output from the pulse generator is received.

7. The UWB short-range radar according to claim 1, **characterized in that**
the burst oscillator is constituted by:
an oscillation unit comprising an amplifier, a resonator connected to an input unit or an output unit of the amplifier, and a feedback circuit which performs positive feedback from an output side of the amplifier to an input side of the amplifier, the oscillation unit performing oscillation at a frequency determined by the resonator; and
a switch circuit which sets the oscillation unit in an oscillation state only in a period in which the pulse signal output from the pulse generator is received.

8. The UWB short-range radar according to claim 2, **characterized in that**
the burst oscillator is constituted by:
an oscillation unit comprising an amplifier, a resonator connected to an input unit or an output unit of the amplifier, and a feedback circuit which performs positive feedback from an output side of the amplifier to an input side of the amplifier, the oscillation unit performing oscillation at a frequency determined by the resonator; and
a switch circuit which sets the oscillation unit in an oscillation state only in a period in which the pulse signal output from the pulse generator is received.

9. The UWB short-range radar according to claim 3, **characterized in that**
the burst oscillator is constituted by:
an oscillation unit comprising an amplifier, a resonator connected to an input unit or an output unit of the amplifier, and a feedback circuit which performs positive feedback from an output side of the amplifier to an input side of the amplifier, the oscillation unit performing oscillation at a frequency determined by the resonator; and
a switch circuit which sets the oscillation unit in an oscillation state only in a period in which the pulse signal output from the pulse generator is received.

10. The UWB short-range radar according to claim 1, **characterized in that**
the transmitting unit is provided with a filter which suppresses a component having a frequency ranging from 23.6 to 24.0 GHz of a frequency component included in the short pulse wave output from the burst oscillator.

11. The UWB short-range radar according to claim 2, **characterized in that**
the transmitting unit is provided with a filter which suppresses a component having a frequency ranging from 23.6 to 24.0 GHz of a frequency component included in the short pulse wave output from the burst oscillator.

12. The UWB short-range radar according to claim 3, **characterized in that**
the transmitting unit is provided with a filter which suppresses a component having a frequency ranging from 23.6 to 24.0 GHz of a frequency component included in the short pulse wave output from the burst oscillator.

13. The UWB short-range radar according to claim 4, **characterized in that**
the transmitting unit is provided with a filter which suppresses a component having a frequency ranging from 23.6 to 24.0 GHz of a frequency component included in the short pulse wave output from the burst oscillator.

14. The UWB short-range radar according to claim 7, **characterized in that**
the transmitting unit is provided with a filter which suppresses a component having a frequency ranging from 23.6 to 24.0 GHz of a frequency component included in the short pulse wave output from the burst oscillator.

15. The UWB short-range radar according to claim 1, **characterized in that**
the antenna of the transmitting unit has a structure obtained by surrounding an antenna element with a cavity, and a resonant frequency of the cavity is caused to fall within a range of 23.6 to 24.0 GHz to reduce gain in the band.

16. The UWB short-range radar according to claim 2, **characterized in that**
the antenna of the transmitting unit has a structure obtained by surrounding an antenna element with a cavity, and a resonant frequency of the cavity is caused to fall within a range of 23.6 to 24.0 GHz to reduce gain in the band.

17. The UWB short-range radar according to claim 3, **characterized in that**
the antenna of the transmitting unit has a structure obtained by surrounding an antenna element with a cavity, and a resonant frequency of the cavity is caused to fall within a range of 23.6 to 24.0 GHz to reduce gain in the band.

18. The UWB short-range radar according to claim 4, **characterized in that**
the antenna of the transmitting unit has a structure obtained by surrounding an antenna element with a cavity, and a resonant frequency of the cavity is caused to fall within a range of 23.6 to 24.0 GHz to reduce gain in the band.

19. The UWB short-range radar according to claim 7, **characterized in that**
the antenna of the transmitting unit has a structure obtained by surrounding an antenna element with a cavity, and a resonant frequency of the cavity is caused to fall within a range of 23.6 to 24.0 GHz to reduce gain in the band.

20. The UWB short-range radar according to claim 10, **characterized in that**
the antenna of the transmitting unit has a structure obtained by surrounding an antenna element with a cavity, and a resonant frequency of the cavity is caused to fall within a range of 23.6 to 24.0 GHz to reduce gain in the band.
